(19) Europäisches Patentamt

European Patent Office

Office européen des brevets

(11) **EP 0 488 088 B1**

(12) **EUROPEAN PATENT SPECIFICATION**

(45) Date of publication and mention
of the grant of the patent:
**02.08.2000 Bulletin 2000/31**

(51) Int. Cl.$^7$: **G01K 7/00**, G01K 3/00

(21) Application number: **91119989.1**

(22) Date of filing: **22.11.1991**

(54) **Overheating detection circuit for detecting overheating of a power device**

Übertemperatur-Detektorschaltung zur Detektierung der Übertemperatur einer Leistungsschaltung

Circuit de détection de surchauffe pour détecter la surchauffe d'un dispositif de puissance

(84) Designated Contracting States:
**DE FR GB IT NL**

(30) Priority: **26.11.1990 JP 32214390**
**10.09.1991 JP 22923891**

(43) Date of publication of application:
**03.06.1992 Bulletin 1992/23**

(73) Proprietor:
**FUJI ELECTRIC CO., LTD.**
**Kawasaki-shi Kanagawa 210 (JP)**

(72) Inventors:
• **Masaharu, Nishiura,**
**c/i Fuji Electric Co.,Ltd.**
**Kawasaki-shi, Kanagawa (JP)**

• **Tatsuhiko, Fujihira,**
**c/i Fuji Electric Co.,Ltd.**
**Kawasaki-shi, Kanagawa (JP)**

(74) Representative:
**Blumbach, Kramer & Partner GbR**
**Radeckestrasse 43**
**81245 München (DE)**

(56) References cited:
**EP-A- 0 174 686**          **EP-A- 0 240 807**
**EP-A- 0 306 396**          **EP-A- 0 409 214**
**DE-A- 3 821 460**          **US-A- 4 667 265**

• OTTO HEINRICH SCHADE: "Thermal Shutdown
Circuitry", RCA TECHNICAL NOTES, Princeton
New Jersey USA, 02-03-1981, vol. , no. 1270,
pages 1 to 3

## Description

The present invention relates to an overheating detection arrangement which is formed in the same semiconductor substrate as that of a power device in a power controlling integrated circuit (power IC), and which can detect an abnormal temperature of the power device.

A power IC includes a control region having a logic region and a power device which are formed in the same substrate. Because a power IC is used with high voltages and large currents, an abrupt increase in the consumption of electric power caused by an abrupt change in a load connected to the device or a shortcircuiting of the load can result in large currents in excess of the rated current flowing through the device, thereby creating a danger that the device will become excessively heated and, in an extreme case, that the device will be destroyed. To protect a power device against such thermal destruction, the temperature of the power device is constantly monitored and, when the temperature of the device exceeds a predetermined temperature or an overheating of the device is detected, some protective action is taken, for example, the power IC is turned-off.

In monitoring a power device, it is preferable to fabricate an overheating detection circuit including a temperature sensor into a substrate in which the power device is formed in order to improve temperature sensitivity and to simplify the circuit arrangement. Typically, however, discrete elements have been used for forming a circuit which interrupts operation of a power device upon detection of eddy currents or an overheating of the power device. In this connection, a thermal sensor using a bipolar transistor as a thermo-sensitive sensor is described in E. Habekotte', Bull, ASE/UCS 76 (1985) 5, 9mars, pp. 272-276.

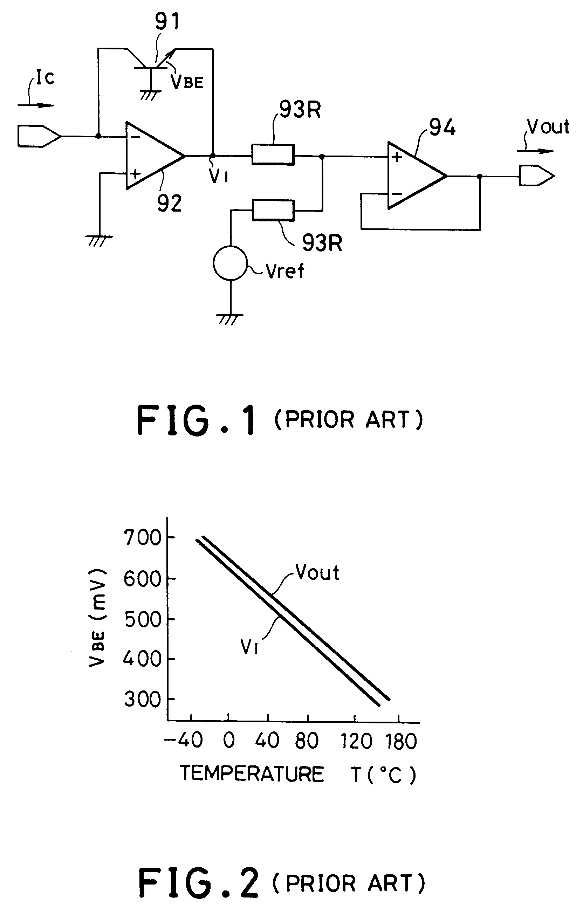

Fig. 1 illustrates a circuit arrangement of a prior art overheating detection circuit which uses the thermal sensor described in the above-cited reference. As shown in Fig. 1, a bipolar transistor 91, operating as a thermal sensor, is inserted into a feedback loop of an operational amplifier 92. An external constant current source (not shown) supplies a collector current IC to the transistor 91. Operational amplifier 92 produces an output voltage $V_1$, which is equal in amplitude but of reverse polarity to a base-emitter voltage $V_{BE}$ of transistor 91. As shown in Fig. 2, the base-emitter voltage $V_{BE}$ varies linearly with and is inversely proportional to temperature T. By properly amplifying the output voltage $V_1$ of the operational amplifier 92 by another operational amplifier 94, an output voltage Vout which varies linearly with respect to temperature T can be obtained.

A feature of the above thermal sensor is that the output voltage Vout varies linearly with respect to change in temperature, and that little error exists over a broad range of temperature change. However, when the thermal sensor is assembled with a power IC as an overheating detection circuit, various problems are encountered. Because the circuit of Fig. 1 uses a constant current circuit with less temperature dependency and a comparator for comparison with the output voltage Vout, a relatively large amount of circuitry is required for the thermal sensor. Further, it is necessary to minimize the temperature dependency of the operational amplifiers 92 and 94, as well as of a reference voltage source Vref. Otherwise, an error arising from the large temperature dependency of each of these components will adversely influence the detected temperature. To remove the adverse influence, most of the circuitry except the bipolar transistor 91 is fabricated and contained in a separate package which is placed at a location such that it is not influenced by the temperature of the power IC. Accordingly, when fabricating the overheating detection circuit in a power IC package, it is necessary to solve the problems associated with the substrate temperature and the increased size of the circuit.

The conventional thermal sensor provides an output signal which varies linearly over a broad range of temperature changes. To the contrary, the conventional overheating detection circuit is designed such that when the temperature of a power device reaches approximately 150°-180° C, it determines that the device temperature has reached an overheating temperature, and produces an output signal. Therefore, the overheating detection circuit must produce an output signal which must vary greatly in accordance with a relatively small temperature range. Thus, the performance requirements of the conventional thermal sensor and overheating detection circuit are quite different from each other.

Earlier EP-A-0 409 214, published on 23.01.91 and claiming priority dates of 19.07.89 and 05.03.90, discloses an overheating detection circuit for use with a power integrated circuit which may be formed in the same substrate as the power integrated circuit. There, a reverse biased diode is connected with the high supply voltage $V_{DD}$. The other terminal of the reverse biased diode is connected to an amplifier which in turn is coupled with a depletion type MOSFET. The node between the amplifier and the MOSFET is connected to a buffer having an internal threshold voltage. Depending on the voltage at the input of the buffer, an output signal is generated signaling, in its one state, an overheating condition.

A similar structure is known from "RCA TECHNICAL NOTES", March 2, 1981, No. 1270. There, a reverse biased diode is connected, with its one terminal, to high potential and, with its other terminal, to an amplifier stage consisting of several transistors and diodes. The output of the amplifier state is connected to a node between a load resistance and a utilization circuitry. In case of too high temperature detected by this circuitry, an output signal is generated by utilization circuitry which causes a cessation of normal operation of a connected circuitry.

EP-A-0 240 807 discloses a circuit arrangement for detection of overtemperature of semiconductor power devices, comprising a bipolar transistor being connected to high potential and detecting the temperature of the power device. The other terminal of the bipolar transistor is connected to a FET the other terminals of which are connected to ground potential. The node between the bipolar transistor and FET is connected to a threshold detector the output signal of which changes when the voltage applied to its input exceeds a predetermined threshold value.

EP-A-0 174 686 discloses a semiconductor temperature sensor being designed as a temperature-dependent semiconductor resistor. At the lower side of a semiconductor substrate, a layer consisting of silicon oxide or silicon nitrate and a surface region of the other, opposite conduction type is provided in order to maintain the predetermined resistance value. This temperature sensor is not designed as overheating protection circuit and does not effect any switching operation in case of too high temperature.

US-A 4 667 265 discloses an IC thermal shutdown circuit wherein a multi-collector transistor is connected, with its base and one collector output, to a reverse biased pn junction. The reverse leakage current flow of the reverse biased pn junction is temperature-dependent so that the current flowing in the collectors of the multi-collector transistor is likewise temperature-dependent. The collector outputs of the multi-collector transistor are connected to diodes and further transistors including PNP transistors and NPN transistors. One of the transistors and a resistor form a threshold circuit, whereas further circuit elements provide a hysteresis behaviour. The IC is shut down when the maximum temperature limit is reached. Further, one terminal of the reverse-biased pn-junction is connected to ground.

An object of the present invention is to provide an overheating detection arrangement comprising a simple circuit construction which is formed in the same substrate as that of a power device, and which can produce a large output signal in response to a detection of a temperature within a range of detection temperatures.

To accomplish the above object, according to a first aspect of the present invention, an overheating detection arrangement as defined in claim 1 is provided.

According to a second aspect of the present invention, the above object can also be achieved by providing an overheating detection arrangement in accordance with claim 7.

The voltage means employed according to the first and second aspects of the present invention as described above preferably comprises, a depletion type MOSFET (metal oxide semiconductor field effect transistor), a resistance layer, or an enhancement type MOSFET connected to high electric potential.

The reverse leakage current flowing in the reverse biased junction means increases along with an increase in temperature of the substrate where the overheating detection circuit and the power device are formed. The leakage current is converted into a voltage depending on the leakage current by the voltage means. The converted voltage signal is checked to determine whether it is within the overheating temperature range by using the signal means having a threshold value. When the voltage signal reaches the overheating temperature range, the threshold means, preferably in the form of a comparator having a threshold voltage, at one input with the voltage depending on the leakage current at the other input, produces output (one value of a two-value signal) indicative of overheating. A protective measure against thermal destruction of the power device can then be taken, for example, a load connected to the power IC can be disconnected in accordance with the output of the comparator.

The overheating detection circuit of the present invention is formed with the logic region in the control region of the power IC and is thus in the same substrate as that of the power device. Various techniques are available to prevent a mutual interaction between the control region and the power device; including, for example, a dielectric isolation method utilizing insulation film, a junction isolation method utilizing a pn junction and a self-isolation method utilizing the pn junction of the device itself in which the device is controlled by the gate isolated with the substrate. The self-isolation method is preferred for reasons of economy. The above and other objects, effects, features and advantages of the present invention will become more apparent from the following description of embodiments thereof taken in conjunction with the accompanying drawings.

Further advantages of the invention will be apparent from a reading of the following description in conjunction with the accompanying drawings, in which:

Fig. 1 is a circuit diagram showing a conventional overheating detection circuit;
Fig. 2 is a graph showing $V_{BE}$ versus temperature characteristic curves useful for explaining the principle of the conventional overheating detection circuit of Fig. 1;
Fig. 3 is a cross-sectional view of an integrated circuit illustrating the junction structure of a first embodiment of an overheating detection circuit according to a first aspect of the present invention;
Fig. 4 is a cross-sectional view of a power device comprising a metal oxide silicon field effect transistor which is formed in the same semiconducting substrate as that of Fig. 3;
Fig. 5 is a circuit diagram of the first embodiment using the overheating detection circuit shown in Fig. 3;
Fig. 6 is a graphical representation of variations of the reverse leakage current of the pn junction versus voltage at different temperatures, and variations of the current of the MOSFET versus voltage useful in explaining an operation of the circuit shown in Fig. 5;

Fig. 7 is a graphical representation of variations of a doping concentration of the p+ type layer of the pn junction versus error in detected temperature;

Fig. 8 is a circuit diagram of an embodiment using an overheating detection circuit according to the second aspect of the present invention;

Fig. 9 is a cross-sectional view of an integrated circuit showing the junction structure of an overheating detection circuit according to the first aspect of the present invention where the power device to be formed in the same semiconducting substrate is an insulated gate bipolar transistor (IGBT);

Fig. 10 is a cross-sectional view of an integrated circuit showing a second embodiment of the first aspect of the invention where a diffusion resistance layer is utilized as the voltage means for producing the voltage depending on the leakage current.

Fig. 11 is a cross-sectional view of an integrated circuit showing a third embodiment of the first aspect at the invention where a polycrystalline silicon resistance layer is utilized as the voltage means for producing the voltage depending on the leakage current.

Fig. 12 is a circuit diagram of the second and third embodiments using the overheating detection circuit shown in Fig. 10 and Fig. 11;

Fig. 13 is a cross-sectional view showing a fourth embodiment of the first aspect of the invention where an enhancement type MOSFET is utilized as the voltage means; and

Fig. 14 is a circuit diagram using the forth embodiment of the overheating detection circuit shown in Fig. 13.

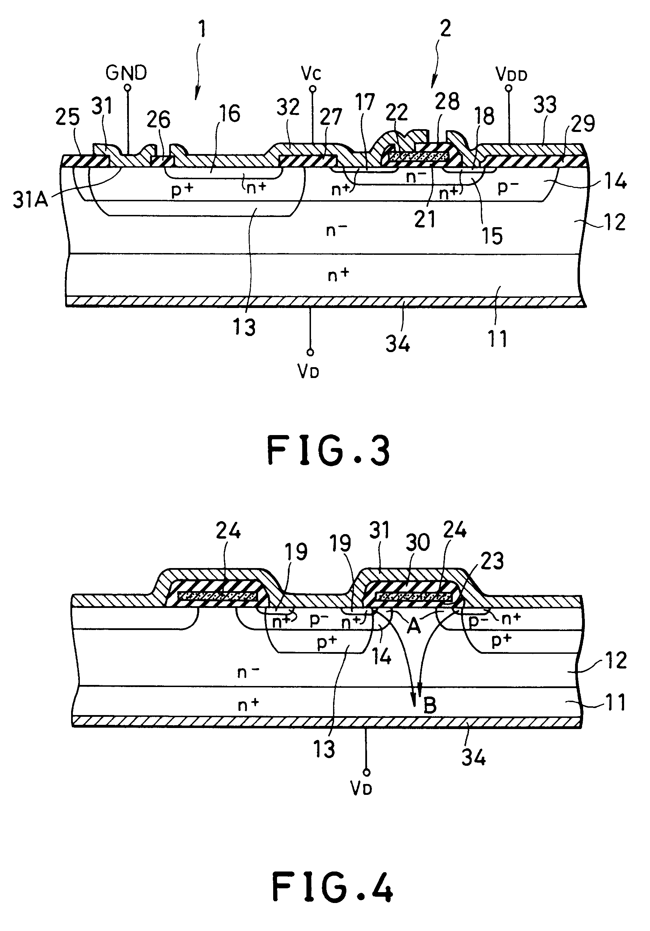

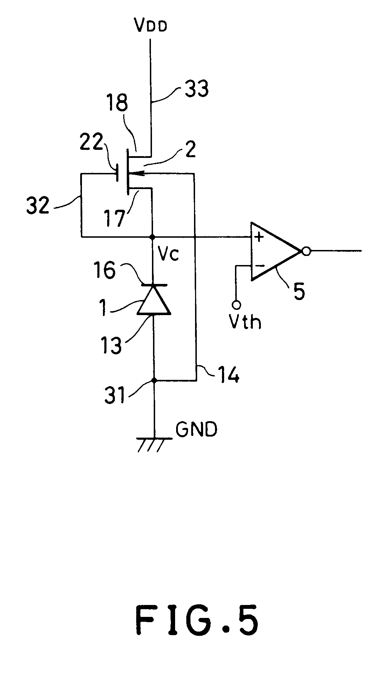

Fig. 3 is a cross-sectional view showing a semiconducting substrate where the overheating detection circuit according to a first embodiment of the present invention is formed in the same semiconducting substrate as that of a MOSFET forming the power device as shown in Fig. 4. In Figs. 3 and 4, a p+ type diffused region 13, a p- type diffused region 14, n- type diffused region 15 and n+ type diffused regions 16, 17, 18 and 19 are formed in a surface of an n- type epitaxial layer 12 formed on an n+ type substrate 11. A gate electrode 22 is formed by polycrystalline silicon on the surface between the n+ type diffused regions 17 and 18 through an insulating film 21.

In the power device shown in Fig. 4, a gate electrode 24 is formed by polycrystalline silicon on the surface between an n+ type diffused region 19 in the p-type diffused region 14 and the exposed portion of the n- type diffused layer 12 through an insulating film 23.

Insulating films 25, 26, 27, 28, 29 and 30 are protective films for exposed junctions on the surface of the substrate and provide insulation between the diffused regions. An electrode 31 connected to a GND terminal contacts the p+ type diffused region 13 through a contacting hole 31A in the insulating films 25, 26. The electrode 31 is electrically connected to the p- type diffused region 14 through the p+ type diffused region 13. An electrode 32 forms a connection between the n+ type diffused areas 16, 17, the gate electrode 22 and a Vc terminal, and an electrode 33 forms a connection between the n+ type region 18 and a Vdd terminal. These electrodes 31, 32 and 33 are made of metal. A metallic drain electrode 34 contacts n+ type substrate 11 on the opposite side of the substrate and is connected to an output terminal $V_D$. The junction means of the present invention comprises the p+ type region 13 and the n+ type region 16. The voltage means in this embodiment of the present invention is constituted of a depletion type MOSFET 2. The depletion type MOSFET 2 comprising of the n+ type regions 17, 18, the n-type region 15, the p- type region, 14 and the electrode 22 produces a voltage depending on a temperature dependent reverse leakage current flow in the pn junction formed by regions 13 and 16. The power device implemented by the MOSFET shown in Fig. 4 operates in a known manner. That is, when a positive voltage more than a threshold level is applied to the gate electrode 24 while a positive voltage is applied to the drain electrode 34, an n channel is produced by inversion of polarity on the surface A of each p- diffused region 14, between the n+ type layer 19 and n- type layer 12 just under the insulating film 23, thereby causing a conductive state by injecting electrons into the drain electrode 34 from the electrode 31 through the source areas 19, the n channel, the n- layer 12 and n+ layer 11 as shown by the arrow B. Therefore, the electric potential of the output terminal Vd having more than 100 to 200 V at the OFF state drops to near GND potential.

Next, the operation of the overheating detection circuit shown in Fig. 3 will be described. The reverse leakage current flowing in the reversely biased pn junction 1 increased alone with the increase in the temperature of MOSFET as shown in Fig. 2. The leakage current is converted into a voltage having a greater temperature dependency by making use of static characteristics of a depletion MOSFET 2 which is connected to pn junction in series through the electrode 32. The converted voltage signal is output from the terminal Vc. A comparator (see Fig. 5) which constitutes the threshold means of the present invention is connected to the terminal Vc. Therefore, check is made as to whether or not the converted voltage signal is within the overheating temperature range by the comparator having a threshold value. When the voltage signal reaches the overheating temperature range, the comparator produces an output. A protection measure (not shown) against thermal destruction of the power device can be taken in which a load connected to the power IC is turned-off in accordance with the output of the comparator.

Fig. 5 is a circuit diagram formed by utilizing the semiconductor structure shown in Fig. 3, and the same components as those in Fig. 3 are indicated by the same reference numerals. The diode 1 consisting of the p+ type region 13 and the n+ type region 16 is connected to the depletion type MOSFET 2 having the n+ type region 17 as source, the n+ type region 18 as drain and the gate electrode 22 in series. The mid-point between the diode 1 and the MOSFET 2 is connected to one input of a comparator 5 which has a threshold voltage $V_{th}$ at its other input.

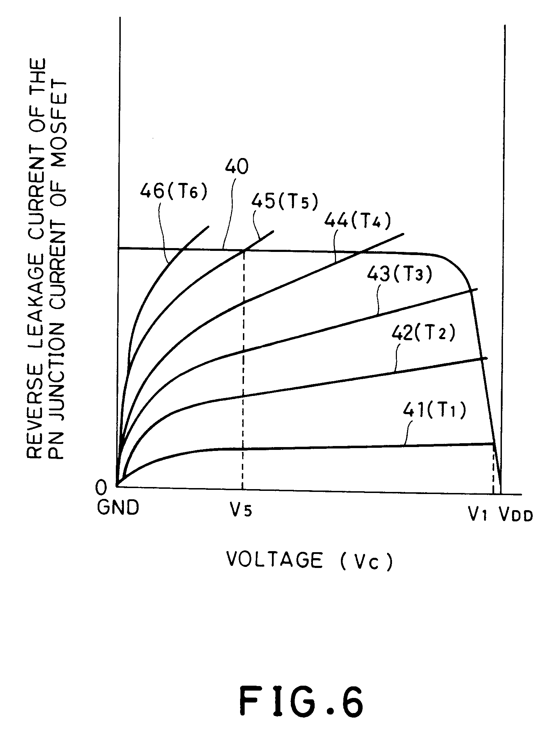

Next, the operation of the overheating detection circuit shown in Fig. 5 will be described with reference to Fig. 6. In Fig. 6, curve 40 depicts a variation of the current of the MOSFET 2 with respect to the electric potential $V_c$ at the mid point between mode 1 and MOSFET 2. The variation of the current of MOSFET 2 is dependent on the form of MOSFET 2 or the concentration of the n- type region 15. Curves 41, 42, 43, 44, 45 and 46 depict a variation of the reverse leakage current of diode 1 with respect to variations of temperature from T1 to T6. The reverse leakage current varies depending on exp(-1/T), and is increased along with the increase in temperature. Fox example, the reverse leakage current, which is $50 \times 10^{-15}$ A at 15°C, increases to 200 nA at 175°C. The reverse leakage current also varies depending on the pn junction area. The electric potential $V_c$ is determined by points where the curve 40 intersects the curves 41-46 at the respective temperatures, so that for example the voltage $V_c$ is at $V_1$ at temperature T1 and varies to $V_5$ at T5. Comparator 5, having a threshold voltage $V_{th}$, produces a detecting signal Vout having one value when the electric potential $V_c$ is lower than the threshold voltage $V_{th}$, and a second value when $V_c$ exceeds the threshold voltage. Therefore, if a control signal derived from the detecting signal Vout is input to the gate electrode of the power device shown in Fig. 4 through a logic circuit (not shown) determining a priority between the control signal and the driving signal of the power device, the power IC can be protected from thermal destruction.

As mentioned above, since the electric potential of the output terminal $V_D$ of the power circuit is changed by the ON-OFF switching of the MOSFET (Fig. 4), errors occur in the detected temperature due to the output voltage potential. That is, the temperature tends to be detected lower than the real temperature when the output voltage is near GND potential by turning ON of the MOSFET. This is caused by the current amplification of the parasitic transistor formed by n+ type region 16, p+ type region 13 and n-type layer 12.

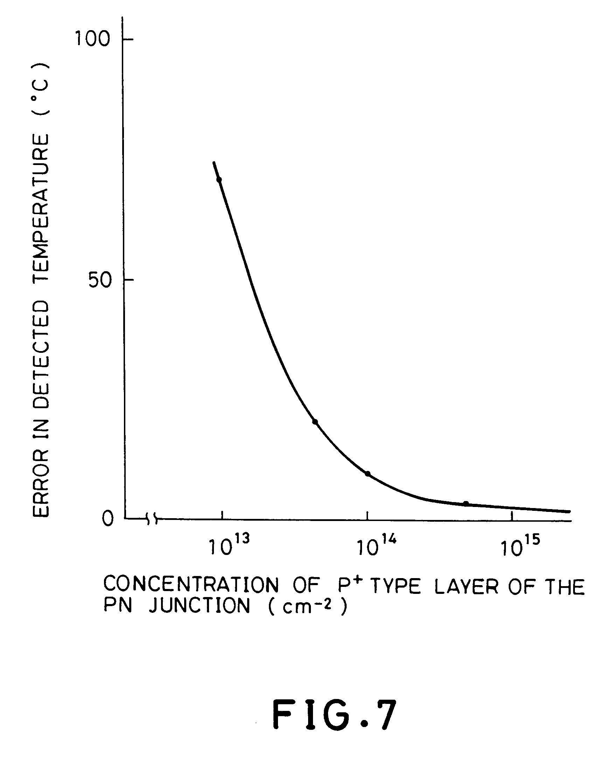

Fig. 7 is a curve showing the development of the error in the detected temperature as a function of concentration of the impurities. As seen, the error in the detected temperature can be suppressed if the parasitic transistor $h_{FE}$ is suppressed by increasing the concentration of p+ type layer 13. Although it depends on the design of the controlling circuit for the power device, a practical overheating detection circuit can be obtained by increasing the concentration of p+ type layer 13, which is on the side of the low impurity concentration layer of the pn junction, to not less than about $5 \times 10^{13}$/cm², preferably about $3 \times 10^{14}$/cm².

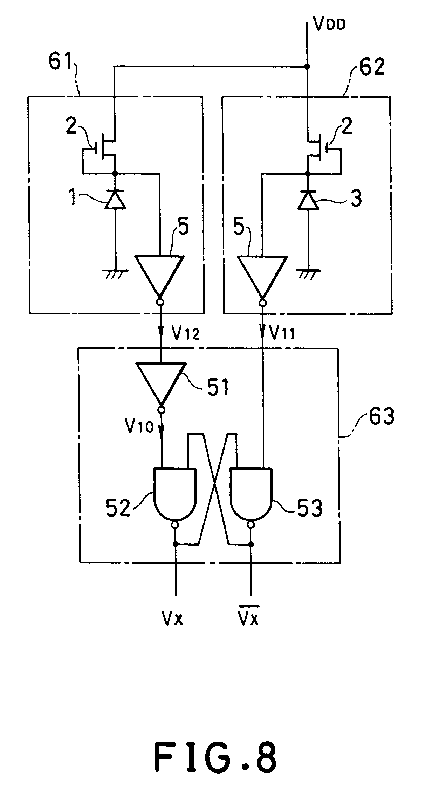

As shown in Fig. 8, the overheating detection circuit according to a second aspect of the present invention comprises a first detecting circuit 61 and a second detecting circuit 62 each having circuit arrangements resembling that of the first aspect of the invention (e.g., Fig. 3), and a hysteresis circuit 63 for receiving output signals $V_{11}$ and $V_{12}$ of the first and second detecting circuits 61 and 62. Diode 1 and FET 2 of detecting circuit 61 and diode 3 and FET 2 of detecting circuit 62 are formed in the same semiconducting substrate as that of the power device shown in Fig. 4. Inverter 5 in each detecting circuit 61, 62 may be integrated in the same substrate if desired. The hysteresis circuit 63 comprises an invertor 51 for inverting the output signal $V_{12}$ of the first detecting circuit 61, and NAND gates 52 and 53 coupled with each other in a feedback manner. The NAND gates 52 and 53 receive the output signal $V_{11}$ of the second detecting circuit 62 as a reset signal, respectively, and output a composite signal $V_x$ and an inverted signal $\bar{v}_x$, respectively. In the circuit arrangement of Fig. 8, a difference of the detecting temperatures between the detecting circuits 61 and 62 is set by properly selecting a junction area of the pn junctions 1 and 3. For instance, if the ratio of the junction area of the diode 1 to that of the diode 3 is 1:4 to 1:5, a temperature difference is produced between the first detecting circuit 61 having the detection temperature of 180°c and the second detecting circuit 62 having the detection temperature of 155°C.

An operation of the overheating detection circuit shown in Fig. 8 will now be described. A threshold voltage of inverter 5 in the first and second detecting circuits 61 and 62, respectively is set to a value corresponding to an overheating detection temperature. The junction area of diode 3 in second detecting circuit 62 is larger than the junction area of diode 1 in first detecting circuit 61 such that detecting temperature T2 of the second detecting circuit 62 is lower than that of the first detecting circuit 61. The temperature rises, passing through threshold temperature $T_2$, and reaches the overheating detection temperature T1 of the first detecting circuit 61. The invertor 51 changes the logic state of its output signal from logic "1" to logic "0". The NAND gates 52 and 53, when receiving the output of invertor 51 at the set terminal, change logical states of the output signals such that the output signal $V_x$ is set to logic "1" and the signal $\bar{v}_x$ is set to logic "0". The changed logic states of the output signals $v_x$ and $\bar{v}_x$ of the NAND gates 52 and 53 are maintained even at the point where the temperature is below the detection temperature within the difference $\Delta T$ (T1-T2), and the output signal $V_{10}$ of the invertor 51 changes its logic state. Next, the temperature drops to the detection temperature T2 of the second detector 62. The second detector 62 detects this and changes the logic state of its output signal to logic "1". At this time, the output signal $V_x$ goes low (logic "0"), and the inverted output signal $\bar{v}_x$ goes high. Then, the hysteresis circuit 63 is again placed in the reset state.

As described above, in the overheating detection circuit of Fig. 8, the two temperature detectors 61 and 62 have the two detection temperatures T1 and T2, respectively; and therefore, the preset temperature difference ΔT is provided. The hysteresis circuit 63 performs a hysteresis operation on the basis of the temperature difference ΔT. Therefore, irregular and short period variations in the temperature T of the power device due to a variation of the load at temperatures near the overheating detection temperature, can be ignored as temperature noise. This fact implies that in an overheating state, the power device can be stably held in the off state in accordance with the output signal $V_x$ and the inverted output signal $\bar{v}_x$. With this reference, adverse effects due to unnecessary protection operations on the load circuit, and electromagnetic noise can be reduced. The resultant overheating protection function is reliable.

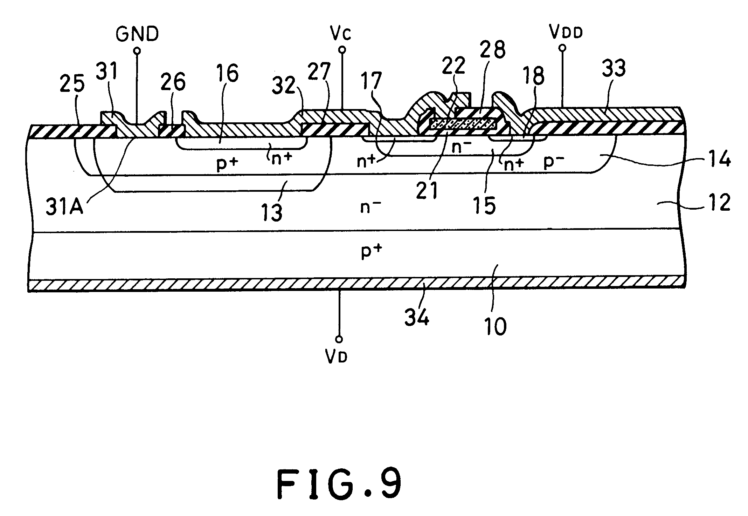

Fig. 9 is a cross-sectional view showing a semiconducting substrate where the overheating detection circuit according to a first embodiment of the present invention is intended to be formed in the same semiconductor substrate as that of a power device (not shown) comprising an insulated gate bipolar transistor (IGBT, IGT or COMFET). In this embodiment, although the p+ type substrate 10 is utilized instead of the n+ type substrate 11 in Fig. 3, the diode consisting of p+ type region 13 and n-type layer 12 as well as the MOSFET consisting of n-type region 15, n+ type region 17, 18 and the gate electrode 22 can be manufactured through the same process steps as in Fig. 3. In addition, the embodiments of the present invention shown in Fig. 3 and Fig. 9 can be applied to a p channel insulated gate type power device with reversed conductive type. In that case, GND is changed to maximum electric potential.

As an alternative to the embodiments in which a depletion type MOSFET is utilized as the voltage conversion means, a resistance or an enhancement type MOSFET may be utilized as the voltage conversion means. In this case, since an n- type layer, n+ type layer or polycrystalline silicon layer are utilized as the resistance, they can be manufactured through similar process steps as in the depletion type MOSFET shown in Fig. 3.

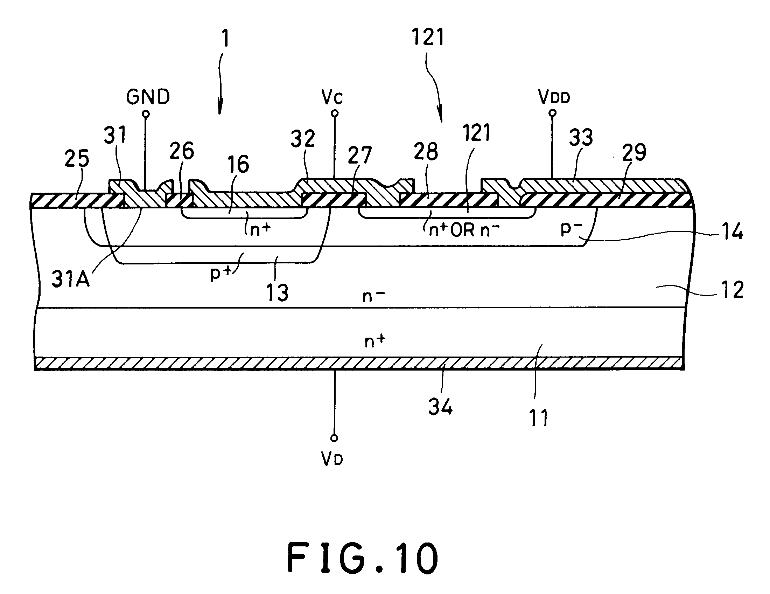

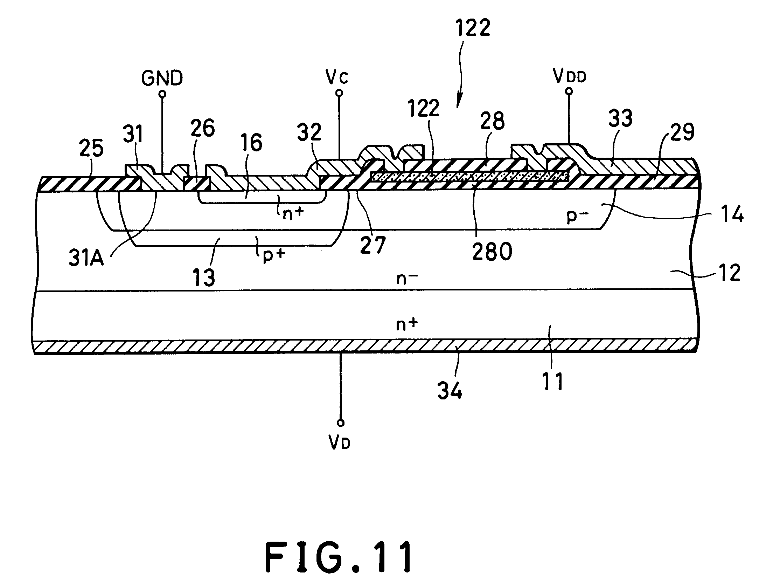

Fig. 10 and Fig. 11 are cross-sectional views showing a semiconducting substrate where the overheating detection circuit according to another embodiment of the present invention is formed in the same semiconductor substrate as that of the MOSFET shown in Fig. 4.

Fig. 10 is a second embodiment of the first aspect of the invention where a diffusion resistance layer is utilized as the voltage means of the present invention. The overheating detection circuit according to the embodiment is formed in the same semiconducting substrate as that of the power device as shown in Fig. 4. Figure 10, p+ type diffused region 13, p- type diffused region 14, n- or n+ type diffused resistance region 121 and n+ diffused region 16 are formed in a surface of an n- type epitaxial layer 12 formed on an n+ type substrate 11. Insulating films 25, 26, 27, 28 and 29 are a protective film for exposed junctions on the surface of the substrate and provide insulation between the diffused regions. An electrode 31 connected to GND terminal contacts the p+ type diffused region 13 through a contacting hold 31A. The electrode 31 is electrically connected to the p- type diffused region 14 through the p+ type diffused region 13. An electrode 32 forms a connection between the n+ type diffused area 16, the diffused resistance region 121 and a Vc terminal and an electrode 33 forms a connection between diffused resistance region 121 and a Vdd terminal. These electrodes 31, 32 and 33 are made of metal. A metallic drain electrode 34 contacts the n+ type substrate 11 and is connected to an output terminal Vd on the opposite side of substrate 11.

Fig. 11 is a third embodiment of the first aspect of the present invention where a polycrystalline silicon resistance layer is utilized as the voltage means of the present invention. This third embodiment mainly differs from the second embodiment shown in Fig. 10 in that the polycrystalline silicon resistance layer 122 contacting electrodes 32 and 33 is provided on p- diffusion region 14 through an insulating film 280 instead of the diffusion resistance layer 121 in Fig. 10. In Fig. 10 and Fig. 11, a pn junction consisting of the p+ diffusion region 13 and n+ diffusion region 16 is equivalent to the reversely biased pn junction of the present invention.

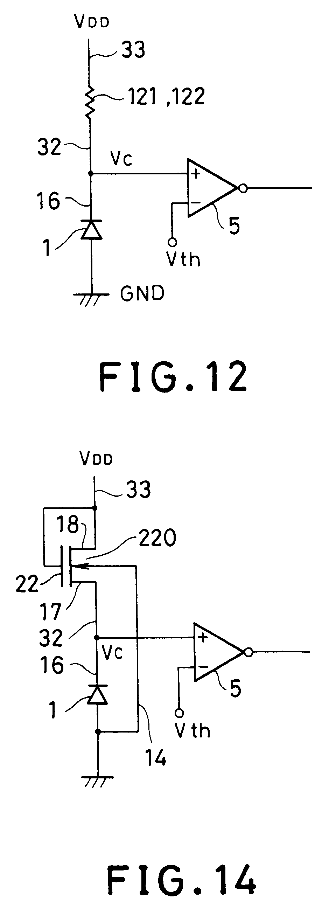

Fig. 12 is a circuit diagram formed by utilizing the integrated circuit construction shown in Fig. 10 and Fig. 11, and the same components as those in Fig. 10 and Fig. 11, are indicated by the same reference numerals. The diode 1 consisting of the p+ type region 13 and the n+ type region 16 is connected to the resistance layers 121, 122 having the electrode 32 at one end and the electrode 33 at another end in series. The mid-point between the diode and the resistance layer is connected to comparator 5 which may be implemented, for example, by a field effect transistor in a known manner.

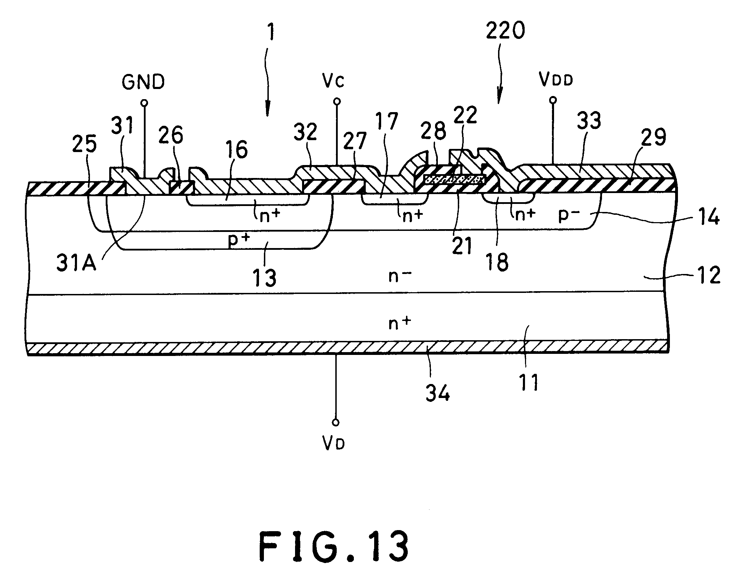

Fig. 13 is a cross section of an integrated circuit which shows a fourth embodiment of the first aspect of the invention wherein an enhancement type MOSFET is utilized as the voltage means of the present invention. The overheating detection circuit according to this embodiment is formed in the same semiconducting substrate as that of the power device shown in Fig. 4.

Fig. 14 is a circuit schematic of the integrated circuit of Fig. 13 and corresponds to the circuit of Fig. 3 wherein a p+ type diffused region 13, a p- type diffused region 14 and n+ diffused region 16, 17 and 18 are formed in a surface of an n- type epitaxial layer 12 on an n+ type substrate 11. A gate electrode 22 is formed on the surface between the n+ type diffused regions 17 and 18 through an insulating film 21 of polycrystalline silicon. Insulating films 25, 26, 27, 28 and 29 form a protective film for exposed junctions on the surface of the substrate and provide insulation between the diffused regions. An electrode 31 connected to GND terminal contacts the p+ type diffused region 13 through a contacting hole 31A. The electrode 31 is electrically connected to the p- type diffused region 14 through the p+ type diffused region 13. An electrode 32 forms a connection between the n+ type diffused areas 16 and 17 and a Vc terminal, and an electrode 33 forms a connection between the n+ diffused region 18, the gate electrode 22 and a Vdd terminal. These electrodes 31, 32 and 33 are made of metal. A metallic drain electrode 34 contact the n+ type substrate 11 and is connected to an output terminal $V_D$ on the opposite side of substrate 11. The junction means of the present invention is constituted of the p+ type region 13 and the n+ type region 16 and the enhancement type MOSFET as the voltage means of the present invention is constituted by the n+ type diffusion regions 17, 18 and electrode 22.

As mentioned above, the resistance or the enhancement type MOSFET shown in Fig. 10, Fig. 11 and Fig. 13 can be utilized as the voltage means instead of the depletion type MOSFET shown in Fig. 3. Although, by increasing the impurity concentration to not less than about $5 \times 10^{13}$/cm$^2$, preferably $3 \times 10^{14}$/cm$^2$, on the side of the low impurity concentration layer in the pn junction, the errors in the detected temperature can be suppressed while the power device is turning ON, there is a disadvantage in that any variation in voltage Vdd will cause the detected temperature to include errors. However, there are some advantages over the first embodiment from the view point of lower cost in that, for example, the process for accumulating a polycrystalline silicon to form the gate electrode 22 is omitted according to the second embodiment shown in Fig. 10 and the process for forming on n-type diffusion layer is omitted according to the third and forth embodiments shown in Fig. 11 and Fig. 13, respectively. The embodiments are thus selected depending on the purpose.

As seen from the foregoing description, in an overheating detection circuit according to the present invention, a reverse leakage current of a reversely biased pn junction is converted into a voltage drop depending on the reverse leakage current by a voltage means. The voltage drop is converted into a corresponding 2-value signal by the threshold means such as a comparator or an inverter with a threshold value. The overheating detection circuit thus described is formed in a substrate in which a power device is also formed. By utilizing a larger temperature dependency of the reverse leakage current of the pn junction diode and the static characteristics of a depletion type MOSFET, a signal corresponding to a temperature change of the power device can be converted into a large voltage change. Therefore, a temperature detection of the overheating detection circuit is very sensitive particularly in the temperature range of 150°C - 180°C. In addition, since the overheating detection circuit and the power device are formed in the same substrate in the same step, a small, inexpensive power IC including an overheating detection circuit is provided.

In a further aspect of the invention, there is provided an overheating detection circuit comprising two detectors, each having a distinct detection temperature and a hysteresis circuit. Irregular and short period variations in the temperature of the power device due to a variation of the load at a temperature near the overheating detection temperature can be ignored as temperature noise if the temperature difference ΔT between the different detection temperatures is appropriately selected. Therefore, adverse effects due to unnecessary repetition of the protection operation, as well as electromagnetic noise caused by it can be eliminated. When an overheating temperature of a power device is detected, the operation of the power device is stopped and its restart is prohibited until it is confirmed that the overheating temperature drops to a temperature in a safety region which is below the lower end of the ΔT temperature range. Therefore, there is provided an overheating protection circuit which is stably, reliably, and safely operable.

In addition, by increasing the impurity concentration to not less than about $5 \times 10^{13}$/cm$^2$ on the side of the low impurity concentration layer in the pn junction, the errors for the detected temperature can be suppressed while the power device is turning ON.

The present invention has been described in detail with respect to preferred embodiments, and it will now be apparent from the foregoing to those skilled in the art that changes and modifications may be made without departing from the scope of the invention as covered by the appended claims.

**Claims**

1. An overheating detection arrangement for detecting overheating of a power integrated circuit, including:

a power device integrated in a semiconductor substrate (11); and
an overheating detection circuit, including:

a reverse biased pn junction (1; 13, 16) formed in the same semiconductor substrate as said power device and having a reverse leakage current flow which is temperature dependent;
voltage means (2; 17, 18, 22; 121; 122) formed on said same semiconductor substrate as said power device and coupled to said pn junction (1; 13, 16) for producing a voltage (Vc) depending on the reverse leakage current flow, said voltage means (2; 17, 18, 22; 121; 122) being formed of a MOSFET or a resistance layer; and

threshold means (5) connected for receiving the voltage and producing a signal when the voltage exceeds a threshold voltage to indicate that said power device is overheated,

wherein the reverse biased pn junction (1; 13, 16) is directly connected, with its one terminal, with ground potential, and the voltage means (2; 17, 18, 22; 121; 122) is directly connected, with its one terminal, with a source potential (Vdd), and, with its other terminal, with the pn junction.

2. The arrangement as claimed in claim 1, characterized in that said semiconductor substrate (11) includes a low impurity concentration layer (13) on one side of said pn junction which has an impurity concentration of not less than $5 \times 10^{13}/cm^2$.

3. The arrangement as claimed in claim 1 or 2, characterized in that said voltage means (2) comprises a depletion-type MOSFET (2) connected for receiving a constant current.

4. The arrangement as claimed in claim 1 or 2, characterized in that said voltage means (2) comprises a diffusion resistance layer (121).

5. The arrangement as claimed in claim 1 or 2, characterized in that said voltage means comprises a polycrystalline silicon resistance layer (122).

6. The arrangement as claimed in claim 1 or 2, characterized in that said voltage means comprises an enhancement-type MOSFET (17, 18, 22).

7. An overheating detection arrangement for detecting overheating of a power integrated circuit, including:

a power device integrated in a semiconductor substrate; and
an overheating detection circuit (61, 62, 63) comprising:

first and second temperature detecting circuits (61, 62), said first temperature detecting circuit (61) having a first temperature threshold and said second temperature detecting circuit (62) having a second temperature threshold lower than the first temperature threshold, each of said first and second temperature detecting circuits (61, 62) including:

a reverse biased pn junction (1) formed in the same semiconductor substrate as said power device and having a reverse leakage current flow which is temperature dependent;

voltage means (2) formed in the same semiconductor substrate as said power device and coupled to said pn junction (1) for producing a voltage (Vc) depending on the reverse leakage current flow, said voltage means being formed of a MOSFET or resistance layer;

threshold means (5) connected to said voltage means (2) for receiving the voltage and producing a signal when the voltage exceeds a threshold voltage corresponding to the respective threshold temperature; and

hysteresis means (63) receiving the signals produced by the respective threshold means (5) of said first and second temperature detecting circuits (61, 62) for producing an overheating signal in response to the signal from the threshold means of said first temperature detecting circuit (61) indicating that said power device is overheated and continuing to produce the overheating signal until the signal from the threshold means of said second temperature detecting circuit (62) is discontinued,

wherein the reverse biased pn junction is directly connected, with its one terminal, with ground potential, and the voltage means is directly connected, with its one terminal, with a source potential (Vdd), and, with its other terminal, with the pn junction.

8. The arrangement as claimed in claim 7, characterized in that said semiconductor substrate includes a low impurity concentration layer on one side of each said pn junction which has an impurity concentration of not less than $5 \times 10^{13}/cm^2$.

9. The arrangement as claimed in claim 7 or 8, characterized in that each said voltage means (2) comprises a depletion-type MOSFET connected for receiving a constant current.

10. The arrangement as claimed in claim 7 or 8, characterized in that each said voltage means (2) comprises a diffusion resistance layer.

11. The arrangement as claimed in claim 7 or 8, characterized in that each said voltage means (2) comprises a polycrystalline silicon resistance layer.

**12.** The arrangement as claimed in claim 7 or 8, characterized in that each said voltage means (2) comprises an enhancement-type MOSFET.

**Patentansprüche**

**1.** Überhitzungsdetektionsanordnung zum Detektieren einer Überhitzung einer integrierten Leistungsschaltung, die aufweist:

> eine Leistungsvorrichtung, die in einem Halbleitersubstrat (11) integriert ist; und
> eine Überhitzungsdetektionsschaltung, die enthält:
> einen in Sperrrichtung vorgespannten pn-Übergang (1; 13, 16), der in demselben Halbleitersubstrat wie die Leistungsvorrichtung ausgebildet ist und einen Leckstromfluss in Sperrichtung aufweist, der temperaturabhängig ist;
> ein Spannungsmittel (2; 17, 18, 22; 121; 122), das auf demselben Halbleitersubstrat wie die Leistungsvorrichtung ausgebildet ist und mit dem pn-Übergang (1; 13, 16) gekoppelt ist zum Erzeugen einer Spannung ($V_c$), die proportional zu dem Leckstromfluss in Sperrichtung ist, wobei das Spannungsmittel (2, 17, 18, 22; 121; 122) aus einem MOSFET oder einer Widerstandsschicht ausgebildet ist; und
> ein Schwellwertmittel (5), das verbunden ist zum Empfangen der Spannung und Erzeugen eines Signales, wenn die Spannung eine Schwellspannung überschreitet, um anzuzeigen, dass die Leistungsvorrichtung überhitzt ist,
> bei der der in Sperrichtung vorgespannte pn-Übergang (1; 13, 16) mit seinem einen Anschluss direkt mit einem Massepotential verbunden ist und das Spannungsmittel (2; 17, 18, 22; 121; 122) mit seinem einen Anschluss mit einem Source-Potential (Vdd) und mit seinem anderen Anschluss mit dem pn-Übergang direkt verbunden ist.

**2.** Anordnung nach Anspruch 1, dadurch gekennzeichnet.

> dass das Halbleitersubstrat (11) eine Schicht (13) niedriger Dotierstoffkonzentration auf einer Seite des pn-Übergangs, die eine Dotierstoffkonzentration von nicht weniger als $5 \times 10^{13}$ /cm$^2$ aufweist, enthält.

**3.** Anordnung nach Anspruch 1 oder 2, dadurch gekennzeichnet,

> dass das Spannungsmittel (2) einen MOSFET (2) vom Verarmungs-Typ aufweist, der zum Empfangen eines konstanten Stromes verbunden ist.

**4.** Anordnung nach Anspruch 1 oder 2, dadurch gekennzeichnet,

> dass das Spannungsmittel (2) eine Diffussionswiderstandsschicht (121) aufweist.

**5.** Anordnung nach Anspruch 1 oder 2, dadurch gekennzeichnet,

> dass das Spannungsmittel eine polykristaline Siliziumwiderstandsschicht (122) aufweist.

**6.** Anordnung nach Anspruch 1 oder 2, dadurch gekennzeichnet,

> dass das Spannungsmittel einen MOSFET (17, 18, 22) vom Anreicherungstyp aufweist.

**7.** Überhitzungsdetektionsanordnung zum Detektieren einer Überhitzung einer integrierten Leistungsschaltung, die enthält:

> eine Leistungsvorrichtung, die in einem Halbleitersubstrat integriert ist; und eine Überhitzungsdetektionsschaltung (61, 62, 63), die aufweist:
> eine erste und eine zweite Detektionsschaltung (61, 62), wobei die erste Temperaturdetektionsschaltung (61) einen ersten Temperaturschwellwert aufweist und die zweite Temperaturdetektionsschaltung (62) eine zweiten Temperaturschwellwert, der niedriger als der erste Temperaturschwellwert ist, aufweist, wobei die erste und die zweite Temperaturdetektionsschaltung (61, 62) jeweils enthalten:
> einen in Sperrichtung vorgespannten pn-Übergang (1), der in demselben Halbleitersubstrat wie die Leistungsvorrichtung ausgebildet ist und einen Leckstromfluss in Sperrichtung aufweist, der temperaturabhängig ist;
> ein Spannungsmittel (2), das in demselben Halbleitersubstrat wie die Leistungsvorrichtung ausgebildet ist und mit dem pn-Übergang (1) gekoppelt ist zum Erzeugen einer Spannung ($V_c$), die proportional zu dem Leckstromfluss in Sperrichtung ist, wobei das Spannungsmittel aus einem MOSFET oder einer Widerstandsschicht ausgebildet ist;
> ein Schwellwertmittel (5), das mit dem Spannungsmittel (2) verbunden ist zum Empfangen der Spannung und Erzeugen eines Signales, wenn die Spannung eine Schwelspannung überschreitet, die der entsprechenden Schwellwerttemperatur entspricht; und
> ein Hysteresemittel (63), das die Signale, die durch das entsprechende Schwellwertmittel (5) der ersten und der zweiten Temperaturdetektionsschaltung (61, 62) erzeugt werden, empfängt, zum Erzeugen eines Überhitzungssignals als Reaktion auf das Signal von dem Schwellwertmittel der ersten Temperaturdetektionsschaltung (61), das anzeigt, dass die Leistungsvorrichtung überhitzt ist, und zum Fortsetzen des Erzeugens des Überhitzungssignals, bis das Signal von dem Schwellwertmittel der zweiten Temperaturdetektionsschaltung (62) unterbrochen wird, bei der der in Sperrichtung vorgespannte pn-Übergang mit seinem einen Anschluss direkt mit einem Massepotential verbunden ist und das Spannungsmittel mit seinem einen Anschluss direkt mit einem Source-Potential (Vdd) verbunden und mit seinem anderen Anschluss mit dem pn-Übergang verbunden ist.

**8.** Anordnung nach Anspruch 7, dadurch gekennzeichnet,

dass das Halbleitersubstrat eine Schicht niedriger Dotierstoffkonzentration auf einer Seite von jedem pn-Übergang, die eine Dotierstoffkonzentration von nicht weniger als $5 \times 10^{13}$ /cm$^2$ aufweist, enthält.

**9.** Anordnung nach Anspruch 7 oder 8, dadurch gekennzeichnet,

dass jedes der Spannungsmittel (2) einen MOSFET vom Verarmungs-Typ aufweist, der zum Empfangen eines konstanten Stromes verbunden ist.

**10.** Anordnung nach Anspruch 7 oder 8, dadurch gekennzeichnet,

dass jedes der Spannungsmittel (2) eine Diffusionswiderstandsschicht aufweist.

**11.** Anordnung nach Anspruch 7 oder 8, dadurch gekennzeichnet

dass jedes der Spannungsmittel (2) eine polykristalline Siliziumschicht aufweist.

**12.** Anordnung nach Anspruch 7 oder 8, dadurch gekennzeichnet,

dass jedes der Spannungsmittel (2) einen MOSFET vom Anreicherungstyp aufweist.

**Revendications**

**1.** Agencement de détection de surchauffe pour détecter la surchauffe

d'un circuit intégré de puissance, comprenant :

- un circuit de puissance intégré dans un substrat semi-conducteur (11) ; et
- un circuit de détection de surchauffe, qui inclut :

    -- une jonction pn à polarisation inverse (1 ; 13, 16) formée dans le même substrat semi-conducteur que ledit circuit de puissance et présentant un courant de frite inverse qui dépend de la température ;
    -- des éléments de tension (2 ; 17, 18, 22 ; 121 ; 122) formés sur le même substrat semi-conducteur que ledit circuit de puissance et couplé a ladite jonction pn (1 ; 13, 16) pour produire une tension (Vc) qui dépend du courant de frite inverse, lesdits éléments de tension (2 ; 17, 18, 22 ; 121 ; 122) étant formés par un transistor MOSFET, ou par une couche de résistance ; et
    -- des éléments de seuil (5) connectés pour recevoir la tension et pour produire un signal lorsque la tension dépasse une tension de seuil pour indiquer que ledit circuit de puissance est surchauffé ;

dans lequel la jonction pn à polarisation inverse (1 ; 13 ; 16) est directement connectée, par l'une de ses bornes, avec le potentiel de terre, et les éléments de tension (2 ; 17, 18, 22 ; 121 ; 122) sont directement connectés, par l'une de leurs bornes, à une tension de source (Vdd) et, par leur autre borne, à la jonction pn.

**2.** Agencement selon la revendication 1, caractérisé en ce que ledit substrat semi-conducteur (11) inclut une couche à faible concentration d'impuretés (13) sur un côté de ladite jonction pn, qui présente une concentration en impuretés qui n'est pas inférieure à $5 \times 10^{13}$/cm$^2$.

**3.** Agencement selon l'une ou l'autre des revendications 1 et 2, caractérisé en ce que lesdits éléments de tension (2) comprennent un transistor MOSFET du type à déplétion (2) connecté pour recevoir un courant constant.

**4.** Agencement selon l'une ou l'autre des revendications 1 et 2, caractérisé en ce que lesdits éléments de tension (2) comprennent une couche de résistance à diffusion (121).

**5.** Agencement selon l'une ou l'autre des revendications 1 et 2, caractérisé en ce que lesdits éléments de tension comprennent une couche de résistance de silicium polycristallin (122).

6. Agencement selon l'une ou l'autre des revendications 1 et 2, caractérisé en ce que lesdits éléments de tension comprennent un transistor MOSFET du type à enrichissement (17, 18, 22).

7. Agencement de détection de surchauffe pour détecter la surchauffe d'un circuit intégré de puissance, incluant :

- un circuit de puissance intégré dans un substrat semi-conducteur ; et
- un circuit de détection de surchauffe (61, 62,63) comprenant :

   -- un premier et un deuxième circuit de détection de température (61, 62), ledit premier circuit de détection de température (61) ayant un premier seuil de température et ledit deuxième circuit de détection de température (62) ayant un deuxième seuil de température inférieur au premier seuil de température, chacun desdits premier et deuxième circuits de détection de température (61, 62) incluant :
   -- une jonction pn à polarisation inverse (1) formée dans le même substrat semi-conducteur que ledit circuit de puissance et ayant un courant de fuite inverse qui dépend de la température ;
   -- des éléments de tension (2) formés dans le même substrat semi-conducteur que ledit circuit de puissance et couplés à ladite jonction pn (1) pour produire une tension (Vc) en fonction du courant de fuite inverse, lesdits éléments de tension étant formés par un transistor MOSFET, ou par une couche de résistance ;
   -- des éléments de seuil (5) connectés auxdits éléments de tension (2) pour recevoir la tension et pour produire un signal lorsque la tension dépasse une tension de seuil correspondant à la température seuil respective ; et
   -- des éléments à hystérésis (63) recevant les signaux produits par les éléments de seuil respectifs (5) dudit premier et dudit deuxième circuit de détection de température (61, 62) pour produire un signal de surchauffe en réponse au signal provenant des éléments de seuil dudit premier circuit de détection de température (61) indiquant que ledit circuit de puissance est surchauffé, et continuant à produire le signal de surchauffe jusqu'à ce que le signal provenant des éléments de seuil dudit deuxième circuit de détection de température (62) soit interrompu,

dans lequel la jonction pn à polarisation inverse est directement connectée, par l'une de ses bornes, à la tension de terre, et les éléments à tension sont directement connectés, par l'une de leurs bornes, à une tension de source (Vdd) et, par leur autre borne, à la jonction pn.

8. Agencement selon la revendication 7, caractérisé en ce que ledit substrat semi-conducteur inclut une couche à faible concentration en impuretés sur un côté de chaque jonction pn, qui présente une concentration en impuretés qui n'est pas inférieure à 5 x $10^{13}$/cm$^2$.

9. Agencement selon l'une ou l'autre des revendications 7 et 8, caractérisé en ce que chacun desdits éléments de tension (2) comprend un transistor MOSFET du type à déplétion, connecté pour recevoir un courant constant.

10. Agencement selon l'une ou l'autre des revendications 7 et 8, caractérisé en ce que chacun desdits éléments de tension (2) comprend une couche de résistance à diffusion.

11. Agencement selon l'une ou l'autre des revendications 7 et 8, caractérisé en ce que chacun desdits éléments de tension (2) comprend une couche de résistance au silicium polycristallin.

12. Agencement selon l'une ou l'autre des revendications 7 et 8, caractérisé en ce que chacun desdits éléments de tension (2) comprend un transistor MOSFET du type à enrichissement.

**FIG.1** (PRIOR ART)

**FIG.2** (PRIOR ART)

# FIG.3

# FIG.4

FIG.5

FIG.6

CONCENTRATION OF P⁺ TYPE LAYER OF THE PN JUNCTION ( cm⁻² )

FIG.7

# FIG.8

FIG.9

EP 0 488 088 B1

FIG.10

EP 0 488 088 B1

FIG.11

EP 0 488 088 B1

V_DD

33

121 ,122

32

Vc

16

1

GND

+

−

5

Vth

# FIG.12

V_DD

33

18

220

22

17

32

Vc

16

1

14

+

−

5

Vth

# FIG.14

FIG.13

EP 0 488 088 B1